# EUROPEAN PATENT APPLICATION

(11) **EP 4 148 791 A1**
(43) Date of publication of application: **15.03.2023**
(21) Application number: 21870547.3
(22) Date of filing: 27.09.2021
(51) Int. Cl.: H01L 27/108

(54) **SEMICONDUCTOR STRUCTURE AND MANUFACTURING METHOD THEREFOR**

(30) Priority: 29.07.2021 CN 202110864749
(71) Applicant: Changxin Memory Technologies, Inc., Hefei City, Anhui 230000 (CN)
(72) Inventor: LIU, Xiang, Hefei City, Anhui 230000 (CN)
(74) Representative: Lavoix
(86) International application number: PCT/CN2021/121068
(87) International publication number: WO 2023/004986

(57) **Abstract**

A semiconductor structure and a method for manufacturing the same. The semiconductor structure includes a substrate, in which isolation trenches are formed, which are configured to divide a part of the substrate into multiple active areas extending in a first direction; first word line structures, each in the isolation trench between two adjacent ones of the active areas in the first direction, and a bottom of the first word line structure being positioned at a first-set-depth position of the substrate; and second word line structures, each located in an active area, and a bottom of the second word line structure being positioned at a second-set-depth position of the substrate. A first depth corresponding to the first-set-depth position is larger than or equal to a second depth corresponding to the second-set-depth position, and the difference between the first depth and the second depth is smaller than a preset value.

## Description

### CROSS-REFERENCE TO RELATED APPLICATION

This application claims priority to Chinese Patent Application No. 202110864749.0, filed on July 29, 2021, entitled "SEMICONDUCTOR STRUCTURE AND METHOD FOR MANUFACTURING SAME", the disclosure of which is hereby incorporated by reference in its entirety.

### TECHNICAL FIELD

The disclosure relates to the technical field of semiconductors, in particular to a semiconductor structure and a method for manufacturing the same.

### BACKGROUND

Memory, such as DRAM (Dynamic Random Access Memory), includes AAs (Active Area) and STI (Shallow Trench Isolation) regions. An APG (Active Passing Gate) is arranged in an active area, and is configured to control the turning-on or turning-off of a recess channel transistor in the active area; and a FPG (Field Pass Gate) is arranged in a STI region and adjacent to active areas, and is configured to connect APGs in different active areas.

As the size of the memory is reduced, coupling effect between the FPGs and the active areas becomes stronger, which causes more serious charge transfer in the active areas to the FPGs under the coupling effect. The coupling effect is prone to increasing leakage current of nearby memory cells, and leads to row hammer effect (i.e., the switch of electrical states of memory capacitors connected to the active areas), which leads to the loss or interference of data in the memory.

### SUMMARY

To solve one or more problems in the related art, embodiments of the disclosure provide a semiconductor structure and a method for manufacturing the same.

The embodiments of the disclosure provide the semiconductor structure, including a substrate, first word line structures and second word line structures.

In the substrate, isolation trenches are formed, which are configured to divide a part of the substrate into multiple active areas extending in a first direction.

Each of the first word line structures is located in the isolation trench between two adjacent ones of the active areas in the first direction, and a bottom of each of the first word line structure is positioned at a first-set-depth position of the substrate; and

Each of the second word line structures is located in an active area, and a bottom of each of the second word line structures is positioned at a second-set-depth position of the substrate.

A first depth corresponding to the first-set-depth position is larger than or equal to a second depth corresponding to the second-set-depth position, and the difference between the first depth and the second depth is smaller than a preset value.

In the foregoing technical solution, the first depth is equal to the second depth.

In the foregoing technical solution, the difference between the first depth and the second depth is smaller than 1/4 of the second depth.

In the foregoing technical solution, a bottom of each of the isolation trenches is positioned at a third-set-depth position of the substrate; and a third depth corresponding to the third-set-depth position is 2 to 2.5 times of the second depth.

In the foregoing technical solution, word line trenches are in the substrate, and the first word line structures and the second word line structures are located in the word line trenches; and each of the first word line structures and each of the second word line structures respectively include a gate insulating layer, a gate layer and a gate dielectric layer, the gate insulating layer is configured to cover an inner wall of each of the word line trench, the gate layer is positioned on the gate insulating layer and is configured to fill a part of the word line trench in depth, and the gate dielectric layer is configured to cover the gate layer and fill a rest part of the word line trench in depth.

In the foregoing technical solution, each of the first word line structures and each of the second word line structures respectively further include a conductive layer positioned between the gate dielectric layer and the gate layer, and a material of the conductive layer includes polysilicon.

In the foregoing technical solution, a material of the gate layer includes titanium nitride, and a material of the gate dielectric layer is silicon nitride.

In the foregoing technical solution, the semiconductor structure is configured to form a Dynamic Random Access Memory (DRAM).

The embodiments of the disclosure further provide a method for manufacturing a semiconductor structure, including the following operations.

A substrate is provided, in which isolation trenches are formed, which are configured to divide a part of the substrate into multiple active areas extending in a first direction.

First word line structures are formed, each of which is in the isolation trench between two adjacent ones of the active areas in the first direction, and a bottom of each of the first word line structures is positioned at a first-set-depth position of the substrate.

Second word line structures are formed, each of which is in an active area, and a bottom of each of the second word line structure is positioned at a second-set-depth position of the substrate.

A first depth corresponding to the first-set-depth position is larger than or equal to a second depth corresponding to the second-set-depth position, and the difference between the first depth and the second depth is smaller than a preset value.

In the foregoing technical solution, the first depth is equal to the second depth.

In the foregoing technical solution, the difference between the first depth and the second depth is smaller than 1/4 of the second depth.

In the foregoing technical solution, the method further includes the following operations.

An isolation insulating layer in each of the isolation trenches is formed.

An isolation dielectric layer is filled in each of the isolation trenches provided with the isolation insulating layer.

The active areas and the isolation trenches each provided with the isolation insulating layer and the isolation dielectric layer are etched, to form word line trenches, each with a bottom at the first-set-depth position in the isolation trench between two adjacent ones of the active areas in the first direction, and to form word line trenches, each with a bottom at the second-set-depth position in an active area.

In the etching process, an etching selection ratio of an etching source to the active areas and to the isolation insulating layers and the isolation dielectric layers are controlled to meet preset conditions, such that the first depth is larger than or equal to the second depth, and the difference between the first depth and the second depth is smaller than the preset value.

In the foregoing technical solution, the etching selection ratio of the etching source to the active areas and to the isolation insulating layers and the isolation dielectric layers meet the preset conditions by selecting a material of the isolation dielectric layers and/or adjusting an etching parameter.

In the foregoing technical solution, forming the first word line structures/the second word line structures includes the following operations.

A gate insulating layer on an inner wall of each of the word line trenches is formed.

A gate layer on the gate insulating layer is formed, and the gate layer is configured to fill a part of the word line trench in depth.

A gate dielectric layer covering the gate layer is formed, and the gate dielectric layer is configured to fill a rest part of the word line trench in depth.

In the foregoing technical solution, the method further includes the following operation.

A conductive layer between the gate layer and the gate dielectric layer is formed, and a material of the conductive layer includes polysilicon.

In the foregoing technical solution, a material of the gate layer includes titanium nitride, and a material of the gate dielectric layer is silicon nitride.

In the foregoing technical solution, a bottom of each of the isolation trenches is positioned at a third-set-depth position of the substrate; and a third depth corresponding to the third-set-depth position is 2 to 2.5 times of the second depth.

Embodiments of the disclosure disclose a semiconductor structure and a method for manufacturing the same. The semiconductor structure includes a substrate, isolation trenches being formed in the substrate, and the isolation trenches being configured to divide part of the substrate into multiple active areas extending in a first direction; first word line structures, each located in the isolation trench between two adjacent ones of the active areas in the first direction, and the bottom of the first word line structure being positioned at a first-set-depth position of the substrate; and second word line structures, each located in an active area, and the bottom of the second word line structure being positioned at a second-set-depth position of the substrate. A first depth corresponding to the first-set-depth position is larger than or equal to a second depth corresponding to the second-set-depth position, and the difference between the first depth and the second depth is smaller than a preset value. The depth of the word line structures arranged in the isolation trench regions relative to the depth of the word line structures arranged in the active areas is controlled, such that the depth of the word line structures arranged in the isolation trench regions is equal to the depth of the word line structures arranged in the active areas, or the depth of the word line structures arranged in the isolation trench regions is slightly larger than the depth of the word line structures arranged in the active areas. Therefore, when a switch in an isolation trench region is turned on, the leakage current path formed by a side wall becomes shorter, and the current flow from the surface of a corresponding isolation trench/active area to the bottom of another word line and the substrate is weakened, thereby reducing the leakage current and mitigating the row hammer effect of memory cells.

### BRIEF DESCRIPTION OF THE DRAWINGS

FIG. 1 illustrates a schematic diagram of adverse effects of leakage current of memory cells in the related art;
FIG. 2 illustrates a schematic diagram of the implementation process of a method for manufacturing a semiconductor structure according to an embodiment of the disclosure;
FIG. 3a to 3g illustrate schematic diagrams of the implementation process of a method for manufacturing a semiconductor structure according to an embodiment of the disclosure;
FIG. 4a-4q illustrate schematic diagrams of the implementation process of another method for manufacturing a semiconductor structure according to an embodiment of the disclosure;
FIG. 5a illustrates a schematic diagram form cross-sectional view of word line structures along an active area extension direction in the related art;
FIG. 5b illustrates a schematic diagram form cross-sectional view of word line structures along an active area extension direction according to an embodiment of the disclosure;
FIG. 6a illustrates a schematic diagram form cross-sectional view of word line structures along a word line extension direction in the related art;
FIG. 6b illustrates a schematic diagram form cross-sectional view of word line structures along a word line extension direction according to an embodiment of the disclosure;
FIG. 7 illustrates a schematic diagram of the simulation result of the current when a switch in a word line structure is turned on in the related art; and
FIG. 8 illustrates a schematic diagram of the simulation result of the current when a switch in a word line structure is turned on according to an embodiment of the disclosure.

### DETAILED DESCRIPTION

Illustrative implementations of the disclosure will be described in more detail below with reference to the drawings. Although illustrative implementations of the disclosure are shown in the drawings, it should be understood that the disclosure may be implemented in numerous forms and should not be limited by the specific implementations illustrated herein. The implementations are merely for a more thorough understanding of the disclosure and enabling those skilled in the art to fully understand the scope of the disclosure.

In the description below, numerous specific details will be provided for a more thorough understanding of the disclosure. However, it is apparent to those skilled in the art that the disclosure may be implemented without one or more of the details. In other embodiments, some technical features known in the art are not described to avoid confusion, i.e., not all features of the actual embodiments are described herein and functions and structures known in the art are not described in detail herein.

In the drawings, the dimensions of layers, regions, elements and relative dimensions thereof may be exaggerated for clarity. Throughout the specification, same reference numerals designate the same elements.

It should be understood that, spatially relative terms, such as "under", "below", "lower", "beneath", "above/on" and "upper" and the like, may be used herein for ease of description to describe one element or feature's relationship to another element or feature as illustrated in the drawings. It should be understood that the spatially relative terms are intended to include different orientations of a device in use or operation in addition to the orientations illustrated in the drawings. For example, if the device in the drawings is turned over, elements or features described as "below", "beneath", or "under" other elements or features may then be oriented "above/on" other elements or features. Therefore, the illustrative terms "below" and "under" may include both an upper and a lower orientation. The device may be otherwise oriented (rotated 90 degrees or at other orientations) and the spatially relative terms used herein are illustrated accordingly.

The terms used herein are merely for the purpose of describing specific embodiments and are not intended to limit the disclosure. As used herein, the singular forms "alan", "one" and "the" are intended to include the plural forms as well, unless the context clearly indicates otherwise. It should be further understood that the terms "comprising" and/or "including," when used in the specification, specify the presence of stated features, integers, steps, operations, elements, and/or components, but do not exclude the presence or addition of one or more other features, integers, steps, operations, elements, components, and/or groups thereof. As used herein, the term "and/or" includes any and all combinations of the associated listed items.

In order to enable the readers to understand the features and technical contents of the embodiments of the disclosure in more detail, the implementations of the embodiments of the disclosure will be described in detail below with reference to the drawings, which are merely for reference only and are not intended to limit the embodiments of the disclosure.

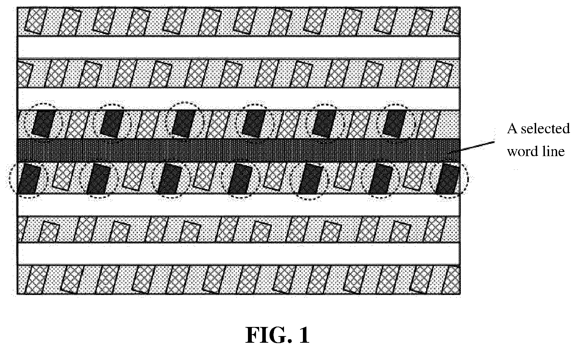

As the size of DRAM is reduced, the distance between word lines becomes increasingly smaller. Switches of FPGs, otherwise known as PWLs (Passing Word Line) positioned in STI regions will affect other nearby memory cells. For example, when the switches of the PWLs are turned on, leakage current channels will be formed along the STI regions and the surface of the substrate, which will increase the leakage current of the nearby memory cells. As shown in FIG. 1, when a certain word line in the middle is selected, the leakage current of the memory cells (corresponding to the areas denoted by dotted-line circles in FIG. 1) near the corresponding PWL parts of the word line increases.

In addition, the bottoms of PWLs may further cause row hammer effect.

Therefore, the technical scheme of the embodiments of the disclosure is provided. According to the embodiments of the disclosure, the influence of leakage current on the nearby memory cells is reduced by reducing the depth of PWLs and meanwhile the row hammer effect is alleviated. Meanwhile, according to the technical scheme of the embodiments of the disclosure, structures of fins in selected transistors of the DRAM are not changed, therefore the completeness of the structures of the fins is ensured and the supply of relatively large drive current is ensured.

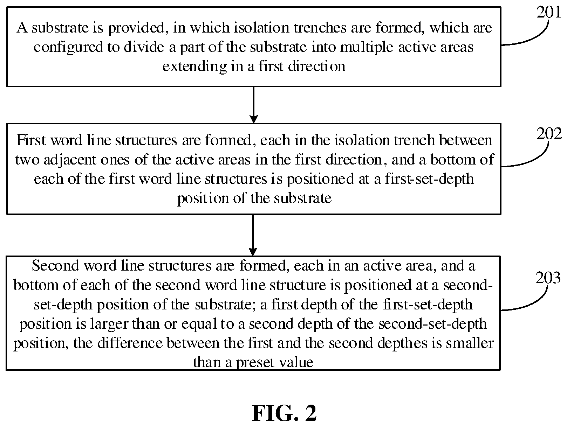

An embodiment of the disclosure provides a method for manufacturing a semiconductor structure. FIG. 2 illustrates a schematic diagram of the implementation process of the method for manufacturing the semiconductor structure according to the embodiment of the disclosure. As shown in FIG. 2, the method includes the following operations.

S201 includes: providing a substrate, and isolation trenches being formed on the substrate, the isolation trenches being configured to divide part of the substrate into multiple active areas extending in a first direction.

S202 includes: forming first word line structures, each of which is located in an isolation trench between two adjacent ones of the active areas in the first direction, and has a bottom positioned at a first-set-depth position of the substrate.

S203 includes: forming second word line structures in the active areas, in which a bottom of each of the second word line structures is positioned at a second-set-depth position of the substrate.

The first depth corresponding to the first-set-depth position is larger than or equal to the second depth corresponding to the second-set-depth position, and the difference between the first depth and the second depth is smaller than a preset value.

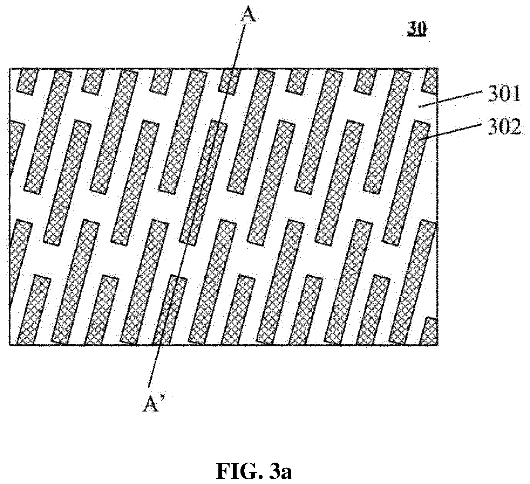

FIG. 3a to 3g illustrate schematic diagrams of the implementation process of the method for manufacturing the semiconductor structure according to the embodiment of the disclosure. The implementation process of the method for manufacturing the semiconductor structure according to the embodiment of the disclosure will be described below with reference to FIG. 3a to 3g.

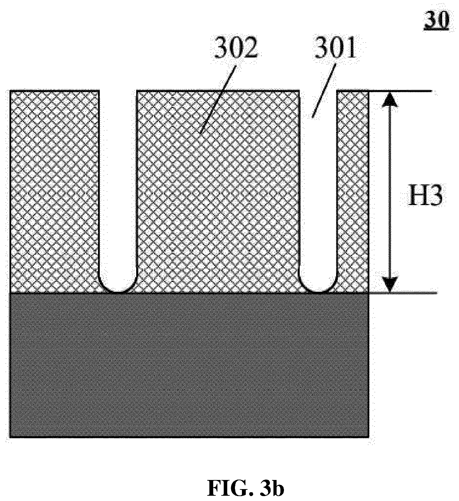

It should be noted that FIG. 3a illustrates a partial schematic diagram from top view of the substrate 30 according to the embodiment of the disclosure; and FIG. 3b illustrates a schematic diagram from cross-sectional view along the direction of AA' of FIG. 3a.

In S201, as shown in FIG. 3a, isolation trenches 301 and multiple active areas 302 are formed on a substrate 30. The isolation trenches 301 are configured to separate adjacent active areas 302 to avoid mutual interference between adjacent active areas 302. In practical application, the isolation trenches may be STI trenches, specifically.

The multiple active areas 302 are arranged in an array mode and extend in a first direction. The first direction may be a direction parallel to the surface of the substrate, that is, parallel to the direction of AA'. As shown in FIG. 3b, the bottoms of the active areas 302 are positioned at a third-set-depth position of the substrate 30 and the third depth corresponding to the third-set-depth position is H3. That is, the substrate 30 is not etched to its bottom at the positions of the isolation trenches 301 and there is a certain remaining thickness at the bottom of the substrate 30.

In practical application, the material of the substrate 30 includes, but is not limited to silicon.

In practical application, the isolation trenches 301 may be formed with an etching process. More specifically, the isolation trenches 301 may be formed by a photoetching process. The active areas 302 may be formed on the substrate 30 by ion doping.

Before the S202, word line trenches need to be formed on the substrate 30.

In some embodiments, the method further includes the operations as follows.

An isolation insulating layer is formed in each isolation trench;

An isolation dielectric layer is filled in each isolation trench provided with the isolation insulating layer.

The active areas and the isolation trenches provided with the isolation insulating layers and the isolation dielectric layers are etched, to form word line trenches each of which has a bottom at a first-set-depth position in a corresponding isolation trench between two adjacent ones of the active areas in the first direction, and to form word line trenches each of which has a bottom at a second-set-depth position in an active area.

In the etching process, an etching selection ratio of an etching source to the active areas and to the isolation insulating layers and the isolation dielectric layers are controlled to meet a preset condition, such that the first depth is larger than or equal to the second depth, and the difference between the first depth and the second depth is smaller than a preset value.

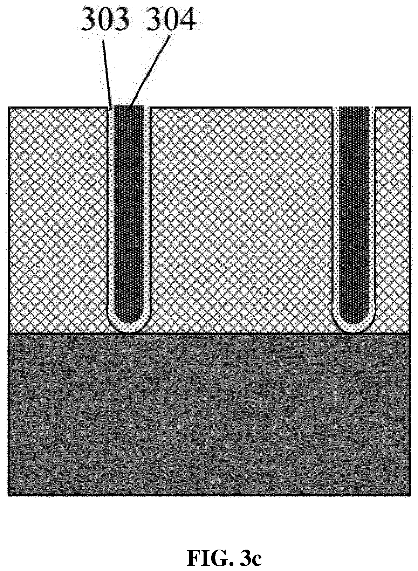

In practical use, as shown in FIG. 3c, the isolation insulating layer 303 is formed in each of the isolation trenches 301, and the isolation dielectric layer 304 is continuously filled in each of the isolation trenches 301.

In some embodiments, the material of isolation insulating layers 303 includes an insulating material, for example, silicon oxide; and the material of isolation dielectric layers 304 includes an insulating material, for example, silicon nitride.

In practical application, the isolation insulating layers 303 and the isolation dielectric layers 304 may be formed through a CVD (Chemical Vapor Deposition) process, a PVD (Physical Vapor Deposition) process or an ALD (Atomic layer deposition) process.

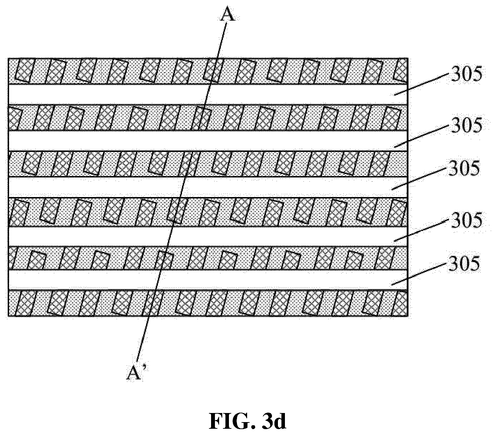

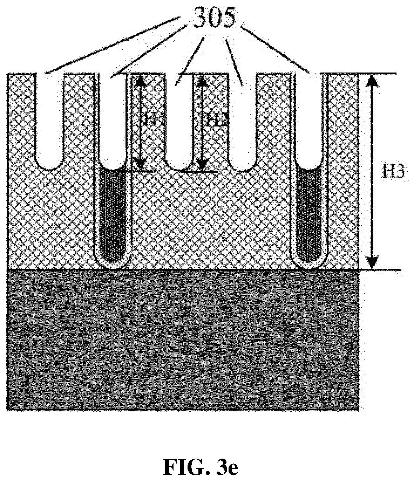

It should be noted that, FIG. 3d illustrates a partial schematic diagram from top view of the word line trenches according to the embodiment of the disclosure; and FIG. 3e illustrates a schematic diagram from cross-sectional view along the direction of AA' of FIG. 3d.

Then, as shown in FIG. 3d and 3e, multiple word line trenches 305, each of which extends in a second direction are formed on the substrate 30. Herein, the second direction is further parallel to the surface of the substrate 30 and an included angle is formed between the second direction and the first direction.

As shown in FIG. 3d, each word line trench 305 penetrates multiple active areas 302 and further penetrates the corresponding isolation trenches 301. Due to the fact that the word line trenches 305 penetrate different structures, when the word line trenches 305 are formed by etching, the depths of one same word line trench may be different at different positions.

As shown in FIG. 3e, the active areas 302 and the isolation trenches 301 provided with the isolation insulating layers 303 and the isolation dielectric layers 304 are etched, word line trenches 305, each with the bottom at a first-set-depth position, are formed in the isolation trenches 301 between two adjacent active areas 302 in the first direction, and word line trenches 305, each with the bottom at a second-set-depth positions, are formed in the active areas 302.

FIG. 3e illustrates the diagram of the situation in which the first depth H1 corresponding to the first-set-depth positions is equal to the second depth H2 corresponding to the second-set-depth positions.

It should be noted that, in the embodiment of the disclosure, the first depth H1 is larger than or equal to the second depth H2, and the difference between the first depth H1 and the second depth H2 is smaller than the preset value.

In some embodiments, the first depth H1 is equal to the second depth H2.

Herein, when the first depth H1 is equal to the second depth H2, when a switch in the corresponding isolation trench region is turned on, the leakage current path formed by the side walls is the shortest, and then the current flow from the surface of the corresponding isolation trench/active area to the bottom of another word line and the substrate is relatively small, such that the leakage current and row hammer effect of memory cells can be well reduced.

Herein, when the first depth H1 is larger than the second depth H2, the difference between the first depth H1 and the second depth H2 is smaller than a preset value, thereby limiting the difference that the first depth H1 is larger than the second depth H2 to an extent. In practical application, the preset value may be adjusted based on the actual situation. Theoretically, the closer the preset value is to 0, the more obvious the effect of reducing the leakage current of memory cells and the row hammer effect is. In some embodiments, the difference between the first depth H1 and the second depth H2 is smaller than 1/4 of the second depth. That is, the preset value may be (1/4)H2, and it is understood that the preset value may be (0, (1/4)H2]. Based on a specific embodiment, the second depth may range from 80 nm to 140 nm, and (1/4) H2 may range from 20 nm to 35 nm.

In some embodiments, the bottoms of isolation trenches 305 are positioned at the third-set-depth position of a substrate; and the third depth H3 corresponding to the third-set-depth positions is 2 to 2.5 times of the second depth H2.

In a specific embodiment, the third depth may range from 160nm to 350nm.

It should be understood that, in the etching process, the etching selection ratio of the etching source to the active areas 302 and to the isolation insulating layers 303 and the isolation dielectric layers 304 may be controlled to meet preset conditions, such that the first depth H1 is larger than or equal to the second depth H2, and the difference between the first depth H1 and the second depth H2 is smaller than the preset value.

In some embodiments, by selecting the material of the isolation dielectric layers 304 and/or changing an etching parameter, the etching selection ratio of the etching source to active areas 302 and to isolation insulating layers 303 and isolation dielectric layers 304 meet preset conditions.

In practical application, when a word line trench 305 is formed in an isolation trench 301 between two adjacent active areas 302 in the first direction, the corresponding isolation dielectric layer 304 is mainly etched; and when a word line trench 305 is formed in an active area 302, the active area 302 is mainly etched. It should be understood that, the etching selection ratio of the etching source to the isolation dielectric layers 304 may be selected to be equal to or slightly larger than the etching selection ratio of the etching source to the active areas, such that the first depth H1 is larger than or equal to the second depth H2, and the difference between the first depth H1 and the second depth H2 is smaller than the preset value. When the material of the active areas is set, it is mainly required to select the material of the isolation dielectric layers 304.

Definitely, the etching selection ratio of the etching source to the active areas 302 and to the isolation insulating layers 303 and the isolation dielectric layers 304 may meet the preset conditions by adjusting the etching parameters. As an example, different depths at different positions may be achieved by controlling the concentration distribution of the etching gas at different positions when the word line trenches are formed. As an example, different depths at different positions may also be achieved by step-by-step etching processes when the word line trenches are formed.

In S202 and S203, the first word line structures 306 and second word line structures 307 are mainly formed in the word line trenches 305. It should be noted that the first word line structures 306 and the second word line structures 307 are generally formed in the word line trenches 305 simultaneously without obvious orders. Herein, the first word line structures 306 may correspond to the foregoing PWLs and the second word line structures may correspond to the foregoing APGs.

It should be understood that the bottom of each first word line structure 306 is mainly related to the bottom of the corresponding word line trench 305 in corresponding isolation trench between two active areas in the first direction; and the bottom of each second word line structure 307 is mainly related to the bottom of the corresponding word line trench 305 in an active area 302.

In some embodiments, the operation of forming first word line structures/second word line structures includes the following operations.

A gate insulating layer on an inner wall of each word line trench is formed.

A gate layer on the gate insulating layer is formed, and the gate layer is configured to fill a part of the word line trench in depth.

A gate dielectric layer covering the gate layer is formed, and the gate dielectric layer is configured to fill the rest part of the word line trench in depth.

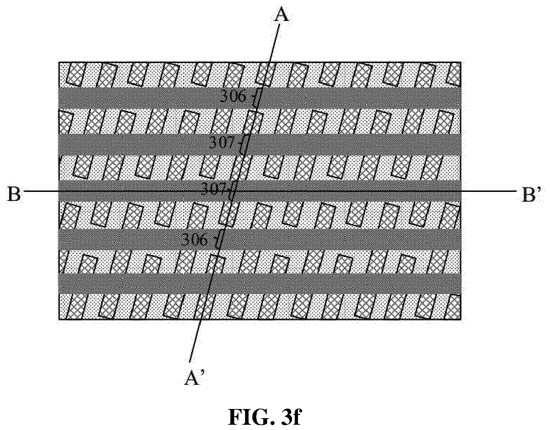

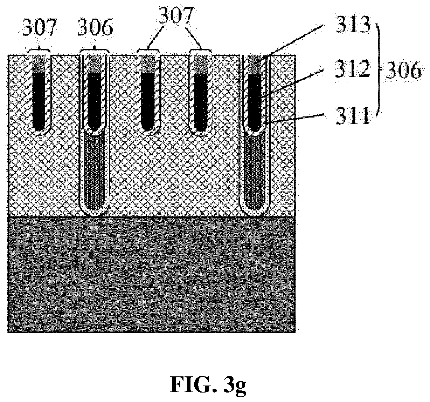

In practical use, the first word line structures 306/the second word line structures 307 are formed as shown in FIG. 3f and 3g.

It should be noted that FIG. 3f illustrates a partial schematic diagram from top view of the word line structures according to the embodiment of the disclosure; and FIG. 3g illustrates a schematic diagram form cross-sectional view along the direction of AA' in FIG. 3f. Herein, the direction of BB' in FIG. 3f is defined as the second direction, i.e. the second direction is a direction in which the word lines extend.

With reference to FIG. 3g, firstly, the gate insulating layers (otherwise known as gate oxide layers) 311 covering the inner walls of the word line trenches are formed. In practical use, the material of the gate insulating layers 311 may include, but is not limited to silicon oxide. The gate insulating layers 311 may be formed through a deposition process, such as the CVD process, PVD process or ALD process.

Then, the gate layers 312 are formed in the word line trenches provided with the gate insulating layers 311, and the material of the gate layers includes a conductive material, for example, titanium nitride. The gate layers 312 are positioned on the gate insulating layers 311 and are configured to fill a part of each word line trench in depth. In practical application, the operation of forming the gate layers 312 may include: filling the material for forming the gate layers into the word line trenches each provided with the gate insulating layer 311, and then etching the material for forming the gate layers to obtain the gate layers configured to fill a part of each word line trench in depth.

Then, the gate dielectric layers 313 are formed in the word line trenches each provided with the gate insulating layer 311 and the gate layer 312, and the gate dielectric layers 313 are configured to cover the gate layers 312 and are positioned on the gate insulating layers 311. In practical application, the material of the gate dielectric layers 313 may include, but is not limited to silicon nitride. The operation of forming the gate dielectric layers 313 may include: filling the material for forming the gate dielectric layers 313 in the word line trenches each provided with the gate layer, and then planarizing the material for forming the gate dielectric layers 313 to obtain the gate dielectric layers 313 configured to fill the rest part of each word line trench in depth.

Herein, the first word line structures 306 and the second word line structures 307 are formed. It should be noted that, due to the fact that both the first word line structures 306 and the second word line structures 307 are directly formed in the word line trenches, the foregoing depth relations of the word line trenches at different positions may be directly reflected by the bottom-depth relations of the first word line structures 306 and the second word line structures 307. That is, the bottom of each first word line structure 306 formed in an isolation trench 301 between two adjacent active areas 302 in the first direction is positioned at the first-set-depth position of the substrate; and the bottom of each second word line structure 307 formed in an active area 302 is positioned at the second-set-depth position of the substrate, and the first depth corresponding to the first-set-depth positions is larger than or equal to the second depth corresponding to the second-set-depth positions, and the difference between the first depth and the second depth is smaller than the preset value.

In some embodiments, the method further includes the following operation.

A conductive layer between the gate layer and the gate dielectric layer is formed, the material of which includes polysilicon.

A specific example will be illustrated below with reference to the foregoing embodiments.

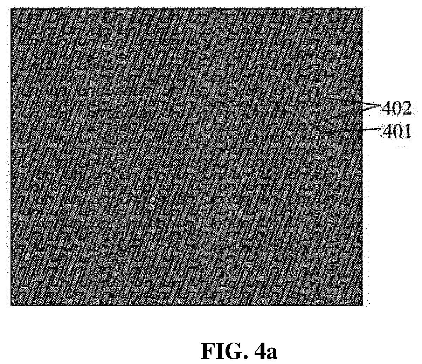

With reference to FIG. 4a to 4q, the situation that the material of a substrate is silicon is taken as an example to illustrate a method for manufacturing a semiconductor structure, including the following steps.

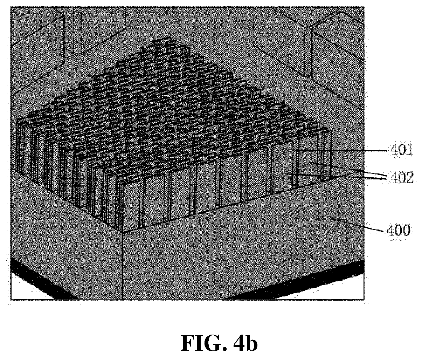

In step 1: as shown in FIG. 4a and 4b, isolation trenches 401 are formed on a substrate 400, and the isolation trenches are configured to divide the substrate partially in thickness into multiple active areas 402 extending in a first direction. Herein, the structural features of the isolation trenches 301 and the active areas 302 of the foregoing embodiment may be referred to for the understanding of the structural features of the isolation trenches 401 and the active areas 402.

It should be noted that FIG. 4a illustrates the first partial schematic diagram from top view of the substrate according to the embodiment of the disclosure; and FIG. 4b illustrates a partial perspective schematic diagram of the substrate of FIG. 4a.

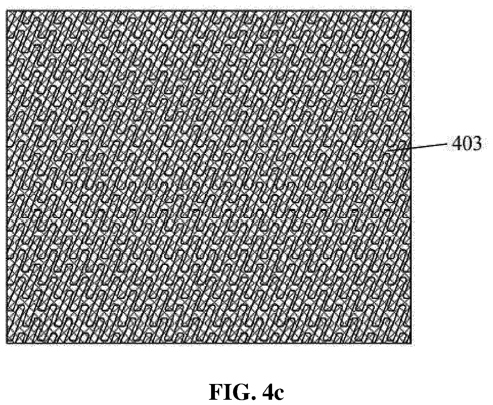

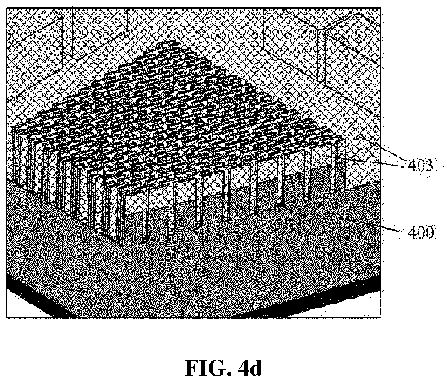

In step 2: as shown in FIG. 4c and 4d, polysilicon is deposited on the substrate 400 to form a polysilicon layer 403; and the polysilicon layer 403 is configured to cover the isolation trenches 301 and the active areas 302.

It should be noted that FIG. 4c illustrates the second partial schematic diagram from top view of the substrate according to the embodiment of the disclosure; and FIG. 4d illustrates a partial perspective schematic diagram of the substrate of FIG. 4c.

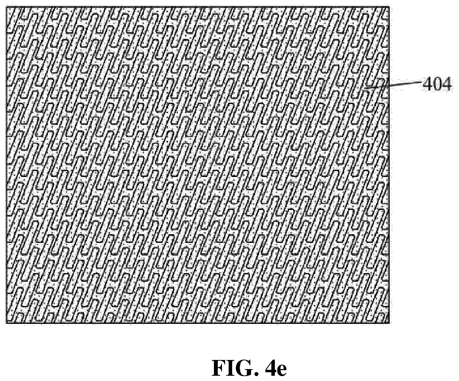

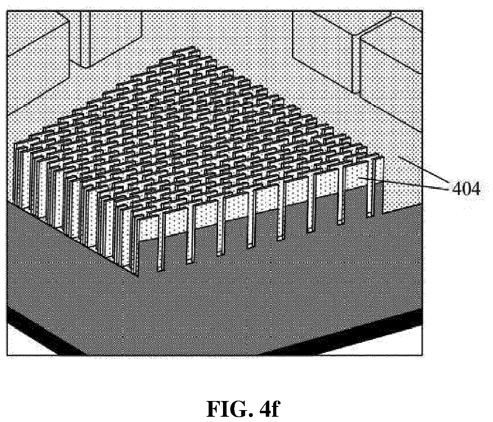

In step 3: as shown in FIG. 4e and 4f, the substrate on which the polysilicon layer 403 is deposited is oxidized in situ, and the polysilicon deposited in step 2 is oxidized to silicon oxide, that is, an insulating layer 404 is formed on the surfaces of the isolation trenches 401 and the active areas 402.

It should be noted that FIG. 4e illustrates the third partial schematic diagram from top view of the substrate according to the embodiment of the disclosure; and FIG. 4f illustrates a partial perspective schematic diagram of the substrate of FIG. 4e.

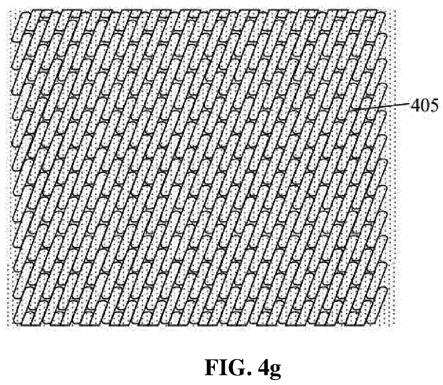

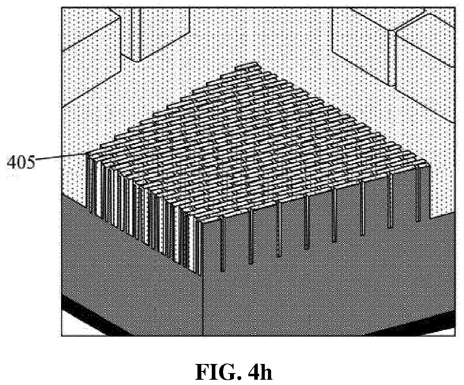

In step 4: as shown in FIG. 4g and 4h, silicon oxide is deposited on the surface of the insulating layer formed in step 3 to form isolation insulating layers 405 (corresponding to the foregoing isolation insulating layers 303). Then, as shown in FIG. 4g, the isolation trenches 401 are not closed by the isolation insulating layers 405.

It should be noted that FIG. 4g illustrates the fourth partial schematic diagram from top view of the substrate according to the embodiment of the disclosure; and FIG. 4h illustrates a partial perspective schematic diagram of the substrate of FIG. 4g.

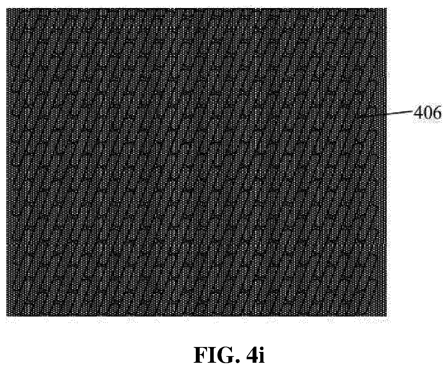

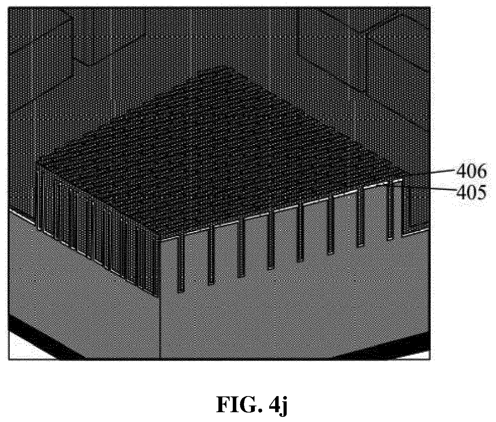

In step 5: as shown in FIG. 4i and 4j, silicon nitride is filled in each isolation trench 401 provided with the isolation insulating layer to form an isolation dielectric layer 406 (corresponding to the foregoing isolation dielectric layers 304). The isolation dielectric layers 406 are configured to fill the isolation trenches 401 and cover the surfaces of the active areas 402. In practical application, the isolation dielectric layers 406 may be formed through a LPCVD (Low Pressure Chemical Vapor Deposition) process.

It should be noted that FIG. 4i illustrates the fifth partial schematic diagram from top view of the substrate according to the embodiment of the disclosure; and FIG. 4j illustrates a partial perspective schematic diagram of the substrate of FIG. 4i.

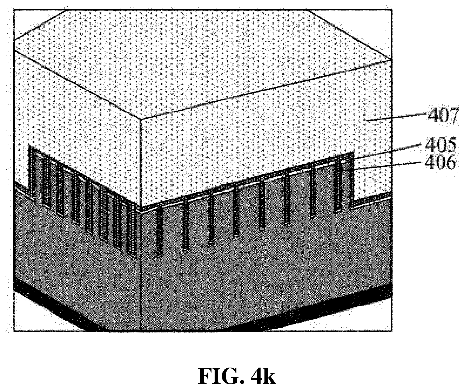

In step 6: as shown in FIG. 4k, an SOD (Spin-On Dielectric) is filled to form a dielectric layer 407. In practical application, the SOD is configured as a coating material in the process of manufacturing silicon thin film, plays a role in insulating between transistors of a semiconductor. The dielectric of the SOD includes carbon-doped silicon oxide.

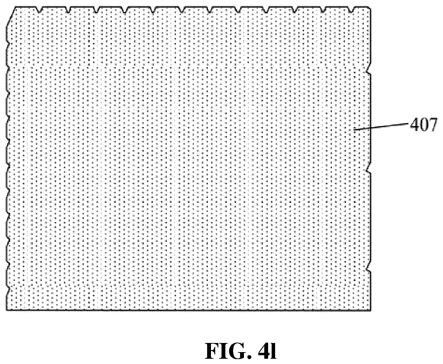

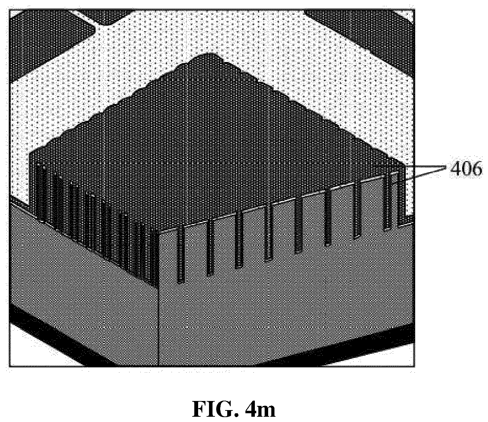

In step 7: as shown in FIG. 4l and 4m, the dielectric layer 407 is planarized to expose the isolation dielectric layers 406. In practical application, CMP (Chemical Mechanical Planarization) may be adopted to planarize the dielectric layer 407.

It should be noted that FIG. 4l illustrates the sixth partial schematic diagram from top view of the substrate according to the embodiment of the disclosure; and FIG. 4m illustrates a partial perspective schematic diagram of the substrate of FIG. 4l.

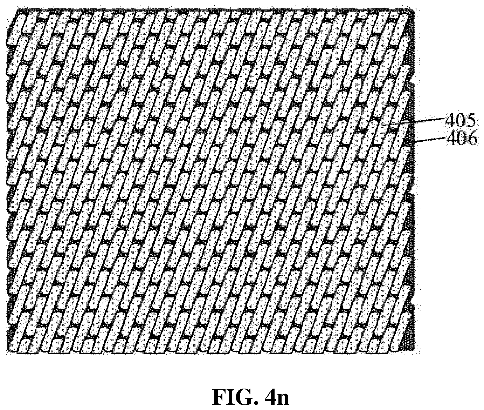

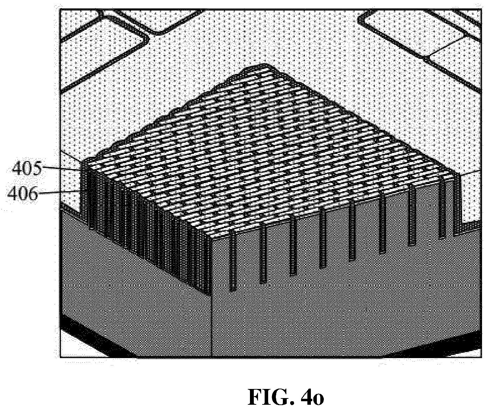

In step 8: as shown in FIG. 4n and 4o, the silicon nitride covering the surfaces of the active areas 302 (that is, the isolation dielectric layers 304 covering the surfaces of the active areas 302) is removed. In practical application, the silicon nitride may be removed through a planarization process.

It should be noted that FIG. 4n illustrates the seventh partial schematic diagram from top view of the substrate according to the embodiment of the disclosure; and FIG. 4o illustrates a partial perspective schematic diagram of the substrate of FIG. 4n.

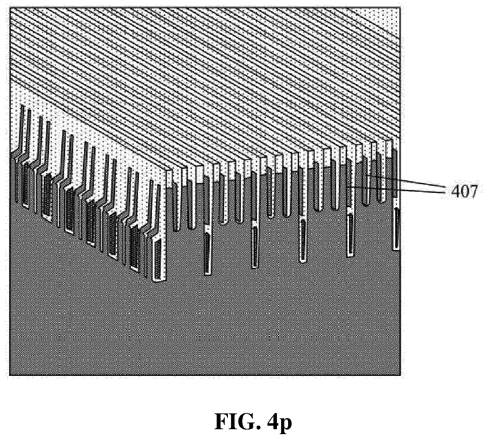

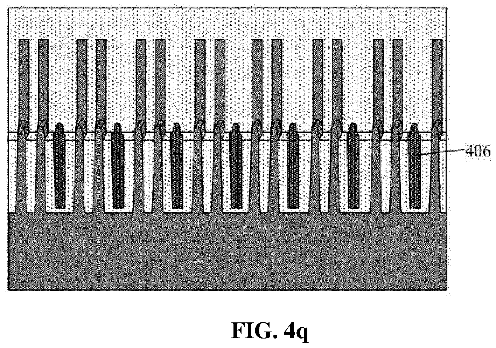

In step 9: as shown in FIG. 4p and 4q, word line trenches 407 are formed on the substrate 400. Word line trenches with the bottoms at a first-set-depth position are formed in the isolation trenches between adjacent active areas in the first direction, and word line trenches with bottoms at a second-set-depth position are formed in the active areas.

It should be noted that FIG. 4p illustrates a perspective schematic diagram of the substrate according to the embodiment of the disclosure; and FIG. 4q illustrates a schematic diagram from cross-sectional view along the word line extension direction of FIG. 4p.

After step 9, word line structures, which include the foregoing first word line structures and the second word line structures, are formed in the word line trenches 407.

To further illustrate the technical scheme of the embodiments of the disclosure, improvements of the embodiments of the disclosure over the related art will be illustrates below from two different perspectives.

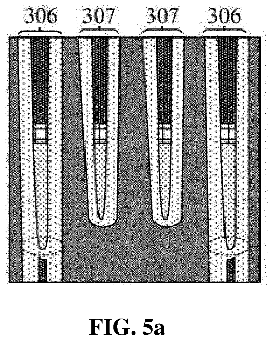

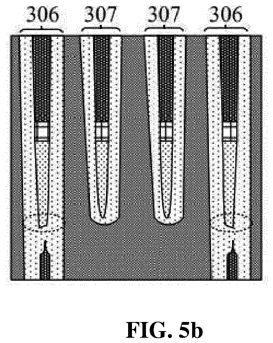

FIG. 5a illustrates a schematic diagram of cross-sectional view of the word line structures along the first direction (the active areas extension direction) in the related art. As shown in FIG. 5a, the depth difference between the bottoms of the first word line structures 306 in the related art (corresponding to the areas denoted by the dotted-line circles) and the bottoms of the second word line structures 307 in the related art is relatively large. As shown in FIG. 5b, the depth difference between the bottoms of the first word line structures 306 of the embodiments of the disclosure (corresponding to the areas denoted by the dotted-line circles) and the bottoms of the second word line structures 307 of the embodiments of the disclosure is relatively small. That is, the bottoms of the first word line structures 306 in the embodiments of the disclosure are shallower than the bottoms of the first word line structures 306 in the related art.

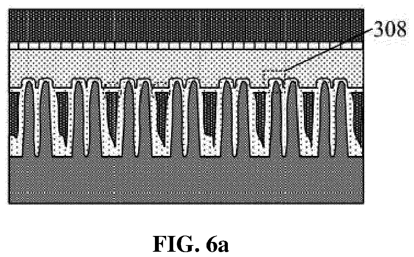

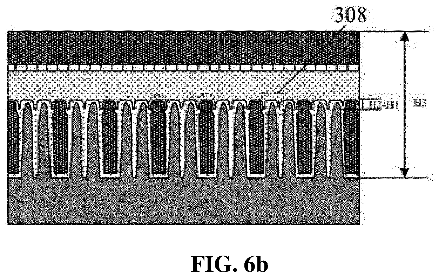

FIG. 6a illustrates a schematic diagram of cross-sectional view of the word line structures along the second direction (word line extension direction) in the related art and FIG. 6b illustrates a schematic diagram form cross-sectional view of the word line structures along the second direction of the embodiments of the disclosure. As shown in FIG. 6a, the height of the silicon nitride at the bottoms of the first word line structures 306 in the related art is quite different from the height of the fins at the bottoms of the second word line structures 307 in the related art (corresponding to the area denoted by the dotted-line box). As shown in FIG. 6b, the height of the silicon nitride at the bottoms of the first word line structures 306 in the embodiments of the disclosure is less different from the height of the fins at the bottoms of the second word line structures 307 in the embodiments of the disclosure (corresponding to the area denoted by the dotted-line box). That is, more silicon nitride remains at the bottoms of the first word line structures 306 (corresponding to the areas denoted by the dotted-line circles) in the embodiments of the disclosure than the bottoms of the first word line structures 306 in the related art (corresponding to the areas denoted by the dotted-line circles).

It should be understood that, the material of the isolation dielectric layers and the corresponding etching method are selected in the embodiments of the disclosure, such that parts of the protruding isolation dielectric layers may be left during the etching of the word line trenches and the fins (the areas denoted by the dotted-line circles in FIG. 6b correspond to the bottoms). Finally, the depth of the PWLs will be reduced without changing the structure of the fins. That is, by improving the material or etching process of the isolation dielectric layers, the appropriate etching ratio is selected to make the isolation dielectric layers to be etched less. Then, the technical scheme based on the embodiments of the disclosure ensures the completeness of the fins, and does not affect the drive current when the leakage current of the memory cells is reduced.

Based on the method for manufacturing the semiconductor structure, the embodiments of the disclosure further provide a semiconductor structure, including a substrate, first word line structures and second word line structures.

On the substrate isolation trenches are formed, and the isolation trenches are configured to divide a part of the substrate into multiple active areas extending in a first direction;

Each of the first word line structures located in the isolation trench between two adjacent ones of the active areas in the first direction, and a bottom of the first word line structure is positioned at a first-set-depth position of the substrate.

Each of the second word line structures is located in an active area, and a bottom of the second word line structure is positioned at a second-set-depth position of the substrate.

A first depth corresponding to the first-set-depth position is larger than or equal to a second depth corresponding to the second-set-depth position, and the difference between the first depth and the second depth is smaller than a preset value.

In some embodiments, the first depth is equal to the second depth.

In some embodiments, the difference between the first depth and the second depth is smaller than 1/4 of the second depth.

In some embodiments, a bottom of each of the isolation trenches is positioned at a third-set-depth position of the substrate; and a third depth corresponding to the third-set-depth position is 2 to 2.5 times of the second depth.

In some embodiments, the substrate is provided with word line trenches in which both first word line structures and second word line structures are positioned; and each of the first word line structures and each of the second word line structures respectively include a gate insulating layer, a gate layer and a gate dielectric layer, the gate insulating layer is configured to cover an inner wall of each of the word line trenches, the gate layer is positioned on the gate insulating layer and is configured to fill a part of the word line trench in depth, and the gate dielectric layer is configured to cover the gate layer and fill a rest part of word line trench in depth.

In some embodiments, each of the first word line structures and each of the second word line structures respectively further include a conductive layer positioned between the gate dielectric layer and the gate layer, and a material of the conductive layer includes polysilicon.

In some embodiments, a material of the gate layer includes titanium nitride and a material of the gate dielectric layer is silicon nitride.

In some embodiments, the semiconductor structure is configured to form a DRAM (Dynamic Random Access Memory).

In order to illustrate the effective effects of the semiconductor structure in the embodiments of the disclosure, the inventor conducted the simulation tests on the semiconductor structure provided in the embodiments of the disclosure and the semiconductor structure provided in the related art, and the test results are described below.

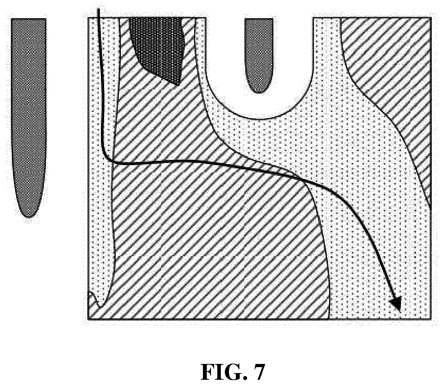

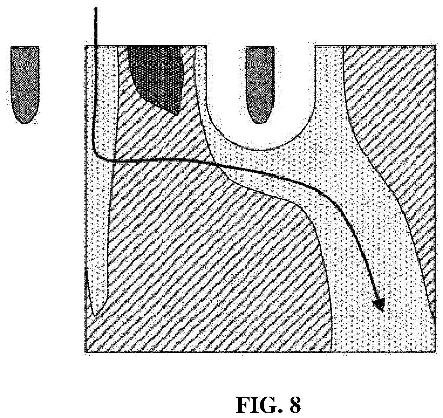

FIG. 7 illustrates a schematic diagram of the simulation result of the current when the switch in a word line structure was turned on in the related art. FIG. 8 illustrates a schematic diagram of the simulation result of the current when the switch in a word line structure was turned on in the embodiments of the disclosure.

As shown in FIG. 7 and 8, when a certain voltage (such as 3V) was applied to a PWL, and the switch in the PWL was turned on, electrons were attracted to gather on the surface of a corresponding isolation trench/active area, and the current flowed to the substrate along the path denoted by the arrow in FIG. 7 or 8 (along the surface of the corresponding isolation trench/active area of the current word line structure to the bottom of another word line structure and then to the substrate). The electron path was opposite to the current path.

In the case that the PWL depth (the left word line in FIG. 7 and 8) is shallow, the leakage current path formed by the side walls becomes shorter, which weakens the current flow from the surface of a corresponding isolation trench/active area to the bottom of another word line structure and the substrate, thereby reducing the leakage current and the row hammer effect of the memory cells.

It should be understood that throughout the specification, the terms such as "an embodiment" or "the embodiment" indicates that at least one embodiment of the disclosure includes the specific features, structures or characteristics related to the embodiments. Therefore, throughout the specification, the terms such as "in one embodiment" or "in an embodiment" do not necessarily refer to a same embodiment. Further, the specific features, structures or characteristics may be incorporated in any suitable manner in one or more embodiments. It should be understood that in numerous embodiments of the disclosure, the serial numbers of the foregoing processes do not denote the execution order, and the execution order of the processes should be determined by the function and inherent logic thereof, and should not limit the implementation process of the embodiments of the disclosure in any way. The serial numbers of the foregoing embodiments of the disclosure are merely for description and do not represent the superiority or inferiority of the embodiments.

The methods disclosed by the embodiments of the method of the disclosure may be combined on a non-conflict basis to obtain new embodiments of the method.

The foregoing merely illustrates the specific implementations of the disclosure, but the scope of the disclosure is not limited thereto. Any person skilled in the art may make variations and modifications without departing from the spirit and scope of the disclosure, which should fall within the scope of the disclosure. Therefore, the scope of the disclosure should be defined by the scope of the claims.

### INDUSTRIAL APPLICABILITY

The depth of the word line structures arranged in the isolation trench regions relative to the depth of the word line structures arranged in the active areas is controlled, such that the depth of the word line structures arranged in the isolation trench regions is equal to or slightly larger than the depth of the word line structures arranged in the active areas. Therefore, when a switch in an isolation trench region is turned on, the leakage current path formed by the side walls becomes shorter, and the current flow from the surface of a corresponding isolation trench/active area to the bottom of another word line and the substrate is weakened, thereby reducing the leakage current and row hammer effect of the memory cells.

## Claims

1. A semiconductor structure, comprising:
a substrate, wherein isolation trenches are formed on the substrate, and the isolation trenches are configured to divide a part of the substrate into multiple active areas extending in a first direction;
first word line structures, each located in the isolation trench between two adjacent ones of the active areas in the first direction, wherein a bottom of the first word line structure is positioned at a first-set-depth position of the substrate; and
second word line structures, each located in one of the active areas, wherein a bottom of the second word line structure is positioned at a second-set-depth position of the substrate,
wherein, a first depth corresponding to the first-set-depth position is larger than or equal to a second depth corresponding to the second-set-depth position, and a difference between the first depth and the second depth is smaller than a preset value.

2. The semiconductor structure of claim 1, wherein the first depth is equal to the second depth.

3. The semiconductor structure of claim 1, wherein the difference between the first depth and the second depth is smaller than 1/4 of the second depth.

4. The semiconductor structure of claim 1, wherein a bottom of each of the isolation trenches is positioned at a third-set-depth position of the substrate; and a third depth corresponding to the third-set-depth position is 2 to 2.5 times of the second depth.

5. The semiconductor structure of claim 1, wherein word line trenches are in the substrate, in which the first word line structures and the second word line structures are located; and each of the first word line structures and each of the second word line structures respectively comprise a gate insulating layer, a gate layer and a gate dielectric layer, the gate insulating layer is configured to cover an inner wall of each of the word line trenches, the gate layer is located on the gate insulating layer and is configured to fill a part of the word line trench in depth, and the gate dielectric layer is configured to cover the gate layer and fill a rest part of the word line trench in depth.

6. The semiconductor structure of claim 5, wherein each of the first word line structures and each of the second word line structures respectively further comprise a conductive layer positioned between the gate dielectric layer and the gate layer, and a material of the conductive layers comprises polysilicon.

7. The semiconductor structure of claim 5, wherein a material of the gate layer comprises titanium nitride and a material of the gate dielectric layer is silicon nitride.

8. The semiconductor structure of any one of claims 1 to 7, wherein the semiconductor structure is configured to form a Dynamic Random Access Memory (DRAM).

9. A method for manufacturing a semiconductor structure, comprising:
providing a substrate, wherein isolation trenches are formed in the substrate, the isolation trenches are configured to divide a part of the substrate into multiple active areas extending in a first direction;
forming first word line structures, each of which is in the isolation trench between two adjacent ones of the active areas in the first direction, wherein a bottom of each of the first word line structures is positioned at a first-set-depth position of the substrate; and
forming second word line structures, each of which is in an active area, wherein a bottom of each of the second word line structures are positioned at a second-set-depth position of the substrate,
wherein, a first depth corresponding to the first-set-depth position is larger than or equal to a second depth corresponding to the second-set-depth position, and a difference between the first depth and the second depth is smaller than a preset value.

10. The method of claim 9, wherein the first depth is equal to the second depth.

11. The method of claim 9, wherein the difference between the first depth and the second depth is smaller than 1/4 of the second depth.

12. The method of claim 9, further comprising:
forming an isolation insulating layer in each of the isolation trenches;
filling an isolation dielectric layer in each of the isolation trenches provided with the isolation insulating layer; and
etching the active areas and the isolation trenches each provided with the isolation insulating layer and the isolation dielectric layer, to form word line trenches, each with a bottom at the first-set-depth position in the isolation trench between two adjacent ones of the active areas in the first direction, and to form word line trenches, each with a bottom at the second-set-depth position in an active area,
wherein, in the etching process, an etching selection ratio of an etching source to the active areas and to the isolation insulating layers and the isolation dielectric layers are controlled to meet preset conditions, such that the first depth is larger than or equal to the second depth, and the difference between the first depth and the second depth is smaller than the preset value.

13. The method of claim 12, wherein the etching selection ratio of the etching source to the active areas and to the isolation insulating layers and the isolation dielectric layers meet the preset conditions by selecting a material of the isolation dielectric layers and/or adjusting an etching parameter.

14. The method of claim 12, wherein forming the first word line structures and the second word line structures comprises:
forming a gate insulating layer on an inner wall of each of the word line trenches;
forming a gate layer on the gate insulating layer, wherein the gate layer is configured to fill a part of the word line trench in depth; and
forming a gate dielectric layer covering the gate layer, wherein the gate dielectric layer is configured to fill a rest part of the word line trench in depth.

15. The method of claim 14, further comprising:
forming a conductive layer between the gate layer and the gate dielectric layer, wherein a material of the conductive layer comprises polysilicon.

16. The method of claim 14, wherein a material of the gate layers comprises titanium nitride and a material of the gate dielectric layers is silicon nitride.

17. The method of claim 9, wherein a bottom of each of the isolation trenches is positioned at a third-set-depth position of the substrate; and a third depth corresponding to the third-set-depth positions is 2 to 2.5 times of the second depth.
